(19)

Europäisches
Patentamt
European
Patent Office
Office européen
des brevets

(11)  **EP 3 502 934 A1**

(12)  **EUROPEAN PATENT APPLICATION**

(43) Date of publication:
26.06.2019   Bulletin 2019/26

(51) Int Cl.:
*G06F 17/50* (2006.01)

(21) Application number: 18214051.7

(22) Date of filing: 19.12.2018

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **21.12.2017   US 201762608724 P**

(71) Applicant: **Quicket GmbH
80807 Munich (DE)**

(72) Inventors:
• **SRONIPAH, Djois Franklin
80807 Munich (DE)**
• **SCHAPOTSCHNIKOW, Philipp
80333 Munich (DE)**

(74) Representative: **Schwarz und Baldus
Patentanwälte
Hermann-Schmid-Straße 10
80336 München (DE)**

(54)  **METHODS AND SYSTEMS FOR GENERATING A REPRESENTATION OF A SEATED PERSON USING FACIAL MEASUREMENTS**

(57)   A system includes an electronic device and a computer-readable storage medium. The computer-readable storage medium includes one or more programming instructions that, when executed, are configured to cause the electronic device to receive a selection of a seat, obtain one or more seat measurements associated with the seat, obtain one or more upper body measurements associated with a user, determine one or more user characteristics associated with the user, determine one or more body measurements for the user based on at least a portion of the one or more upper body measurements and/or at least a portion of the one or more user characteristics, generate a visual representation of the user relative to the seat based on at least a portion of the seat measurements and at least a portion of the body measurements, and cause the visual representation to be displayed on a display device of the electronic device.

FIG. 1

EP 3 502 934 A1

**Description**

CROSS-REFERENCE TO RELATED APPLICATIONS

This application claims the benefit of U.S. Provisional Patent Application No. 62/608,724 filed on December 21, 2017, which is incorporated by reference in its entirety.

BACKGROUND

There are many events or locations where the comfort of a seat is of utmost importance to a patron. These include, for example, airplane seats, train seats, car seats, stadium seats, theater seats and/or the like. Often, the comfort of a seat is just as important, and sometimes more important to a patron than the seat location. This is especially true in situations where a patron is seated for long durations of time, such as during international travel.

Often, patrons are aware of the location of a seat they select. However, they are unable to determine how comfortable that seat may be. In some instances, a patron may be able to obtain specific measurements of a seat. But the patron is unlikely to determine from those measurements exactly how comfortable the seat will be considering the patron's specific physical body type and/or body measurements.

SUMMARY

In an embodiment, a system includes an electronic device and a computer-readable storage medium. The computer-readable storage medium includes one or more programming instructions that, when executed, are configured to cause the electronic device to receive a selection of a seat, obtain one or more seat measurements associated with the seat, obtain one or more upper body measurements associated with a user, determine one or more user characteristics associated with the user, determine one or more body measurements for the user based on at least a portion of the one or more upper body measurements and/or at least a portion of the one or more user characteristics, generate a visual representation of the user relative to the seat based on at least a portion of the seat measurements and at least a portion of the body measurements, and cause the visual representation to be displayed on a display device of the electronic device.

Optionally, the system may receive a selection of the seat from a seat map from a user. The one or more seat measurements associated with the seat may include one or more measurements associated a seat base of the seat, a seat back of the seat, a headrest of the seat, and/or an arm rest of the seat.

The system may query a measurement system located remotely from the electronic device for the one or more seat measurements using a unique identifier associated with the seat. The electronic device may receive, from an image capture device, an image of the seat, and perform one or more image processing techniques on the image to obtain the one or more seat measurements associated with the seat.

The electronic device may scan, by an infrared scanner of the electronic device, at least a portion of the user's face to generate a three-dimensional map of the user's face.

The system may obtain from an image capture device, an image of the user's face, and apply one or more facial recognition algorithms to identify the one or more user characteristics.

The system may generate a visual representation of the user relative to the seat that includes an indication of a comfort level associated with the seat for the user.

The electronic device may send one or more instructions to a controller associated with the seat to adjust a position of the seat. The one or more instructions may include one or more of the body measurements. The controller may be configured to cause the position of the seat to be adjusted in order to accommodate the one or more body measurements.

BRIEF DESCRIPTION OF THE DRAWINGS

FIG. 1 illustrates an example method of generating a representation of a seat location.
FIGS. 2A-2D illustrate example types of upper body measurements.
FIG. 3 illustrates schematically an example scanning device to obtain upper body measurements.
FIGS. 4A-4L illustrates example types of body measurements.
FIG. 5 illustrates an example visual representation showing one or more user body measurements.
FIG. 6 illustrates example visual representations.
FIG. 7 illustrates an example system of generating a representation of a seat location.

FIG. 8 illustrates a block diagram of example hardware that may be used to contain or implement program instructions.

DETAILED DESCRIPTION

This disclosure is not limited to the particular systems, methodologies or protocols described, as these may vary. The terminology used in this description is for the purpose of describing the particular versions or embodiments only, and is not intended to limit the scope.

As used in this document, the singular forms "a," "an," and "the" include plural reference unless the context clearly dictates otherwise. Unless defined otherwise, all technical and scientific terms used herein have the same meanings as commonly understood by one of ordinary skill in the art. All publications mentioned in this document are incorporated by reference. All sizes recited in this document are by way of example only, and the invention is not limited to structures having the specific sizes or dimension recited below. As used herein, the term "comprising" means "including, but not limited to."

The following terms shall have, for purposes of this application, the respective meanings set forth below:

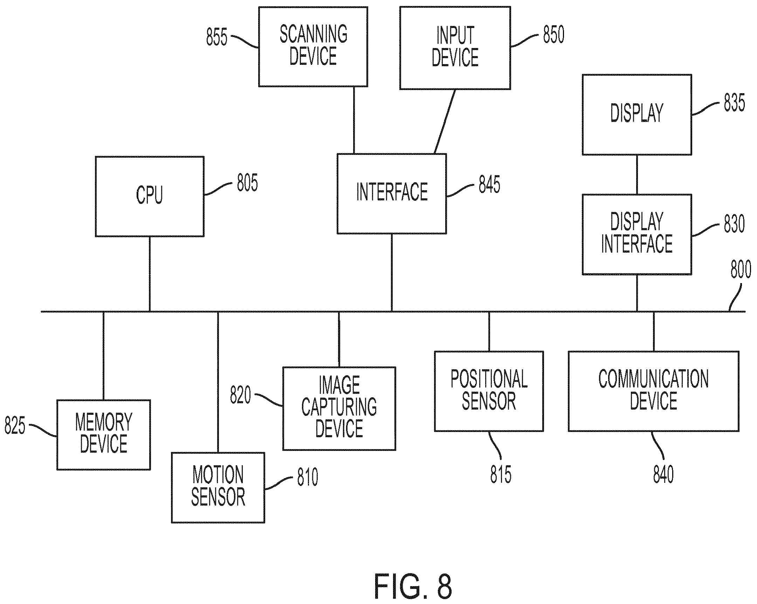

An "electronic device" or a "computing device" refers to a device or system that includes a processor and memory. Each device may have its own processor and/or memory, or the processor and/or memory may be shared with other devices as in a virtual machine or container arrangement. The memory will contain or receive programming instructions that, when executed by the processor, cause the electronic device to perform one or more operations according to the programming instructions. Examples of electronic devices include personal computers, servers, mainframes, virtual machines, containers, gaming systems, televisions, digital home assistants, and mobile electronic devices such as smartphones, fitness tracking devices, wearable virtual reality devices, Internet-connected wearables such as smart watches and smart eyewear, personal digital assistants, cameras, tablet computers, laptop computers, media players and the like. Electronic devices also may include appliances and other devices that can communicate in an Internet-of-things arrangement. Electronic devices also may include components of vehicles such as dashboard entertainment systems and operation systems. In a client-server arrangement, the client device and the server are electronic devices, in which the server contains instructions and/or data that the client device accesses via one or more communications links in one or more communications networks. In a virtual machine arrangement, a server may be an electronic device, and each virtual machine or container also may be considered an electronic device. In the discussion below, a client device, server device, virtual machine or container may be referred to simply as a "device" for brevity. Additional elements that may be included in electronic devices will be discussed below in the context of FIG. 8.

The terms "processor" and "processing device" refer to a hardware component of an electronic device that is configured to execute programming instructions. Except where specifically stated otherwise, the singular terms "processor" and "processing device" are intended to include both single-processing device embodiments and embodiments in which multiple processing devices together or collectively perform a process.

The terms "memory," "memory device," "data store," "data storage facility" and the like each refer to a non-transitory device on which computer-readable data, programming instructions or both are stored. Except where specifically stated otherwise, the terms "memory," "memory device," "data store," "data storage facility" and the like are intended to include single device embodiments, embodiments in which multiple memory devices together or collectively store a set of data or instructions, as well as individual sectors within such devices.

A "seat" refers to an apparatus on which a person can sit. Example seats include, without limitation, car seats, airplane seats, train seats, bus seats, chairs, benches, theater seats, stadium seats, sofas, love seats and/or the like.

This disclosure describes various methods and systems for generating a visual representation of a user's body relative to a seat location based on one or more upper body measurements of the user. Such systems may be implemented, in whole or in part, as a cloud-based solution, an installed solution and/or a mobile application. For instance, one or more of the systems described in this disclosure may be implemented as a mobile application resident on a user's mobile device, such as a smartphone or tablet. As another example, one or more of the systems described in this disclosure may be implemented as part of a website, such as a website for purchasing seats (airplane seats, train seats, theater seats, etc.).

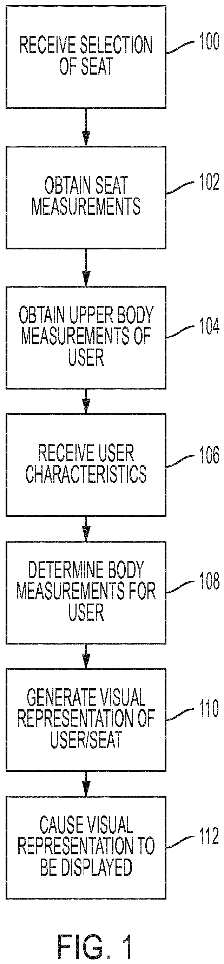

FIG. 1 illustrates an example method of generating a representation of a seat location according to an embodiment. As illustrated in FIG. 1, an electronic device may receive **100** a selection of an identified seat. An electronic device may receive **100** a selection of an identified seat from a user. For instance, a user may select a particular seat and an electronic device may receive an indication associated with the selection. For example, a user may select a seat location from a visual representation such as a seat map. For instance, when purchasing an airplane seat, a user may be presented with a seat map of available seats on the flight, and the user may select, from the seat map, the seat that the user would like.

As another example, a user may indicate preferences associated with a seat location, and an electronic device may identify a seat meeting those preferences. For instance, a user who is selecting a theater seat may indicate a preference for orchestra center seats on the aisle, and an electronic device may identify or select a seat having these characteristics.

In an embodiment, an electronic device may obtain **102** one or more seat measurements associated with the identified seat. The seat measurements may include, without limitation, one or more dimensions associated with a seat base, a seat back, a headrest, arm rests and/or other components of a seat. For instance, a seat measurement may be seat pitch (SP). Seat pitch refers to the space between a point on one seat and the same point on a seat in front of it. Another example of a seat measurement is seat width (SW), which refers to the width of a seat base. Additional and/or alternate measurements may be used within the scope of this disclosure.

An electronic device may obtain **102** one or more seat measurements from a measurement system. In an embodiment, a measurement system may be a remote system in communication with an electronic device via a communication network. A measurement system may store one or more measurements associated with various seats. For instance, a measurement system may store one or more measurements associated with one or more seats based on their location. For instance, a measurement system may store one or more measurements associated with one or more planes operated by a certain carrier.

An electronic device may obtain **102** one or more seat measurements from a measurement system by querying the system using the seat indication. For instance, an indication of a seat may include a unique identifier associated with a seat. An electronic device may provide such a unique identifier to a measurement system and may obtain one or more seat measurements that correspond to the seat. In various embodiments, one or more seat measurements for a seat may be accessible via a schematic diagram of a seat that is store, such as, for example, a CAD drawing.

In another embodiment, a measurement system may reside in memory of the electronic device. For instance, one or more of the systems (and or components of the systems) described in this disclosure may be implemented via one or more applications that reside on an electronic device. As such, a measurement system may be implemented within such applications. In other embodiments, an electronic device may obtain **102** one or more seat measurements from a user. For instance, a user may enter one or more seat measurements via the electronic device.

In other embodiments, an electronic device may obtain **102** one or more seat measurements from an image or video showing a seat. For instance, a user may use an imaging device, such as the camera of his or her smartphone, to take a picture of a seat. The electronic device may access the image (such as from the stored photographs on the electronic device), and perform one or more image processing techniques on the image to estimate one or more dimensions of the seat.

In various embodiments, an electronic device may obtain **104** one or more upper body measurements associated with a user. To provide the most applicable and useful information, the user whose facial measurements are obtained should be the person who will ultimately be sitting in the seat. However, there may be situations where the user interacting with the electronic device is not the user who is ultimately occupying the seat. For instance, a wife who is purchasing an airplane ticket for her husband may provide her facial measurements to the electronic device to estimate how comfortable the seat will be for her husband.

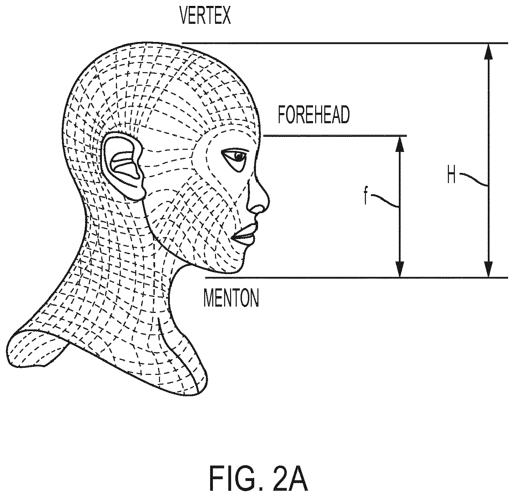

Upper body measurements refer to measurements of one or more physical characteristics of a user that occur above the waist. Example upper body measurements may include, without limitation, measurements associated with a user's head, face and/or shoulders. For instance, upper body measurements may include, without limitation, a user's face height, jaw length, face width, a length of a user's nose, a height of a user's head, and a width of a user's shoulders. FIGS. 2A-2D demonstrate schematically upper body measurements according to various embodiments. As illustrated by FIG. 2A, one upper body measurement that may be obtained (for example, via a near-field depth scan) is the height of user's head, $H$, which may be the height measured from a vertex of a user's head to the user's menton. As also illustrated by FIG. 2A, another upper body measurements that may be obtained is a height of a user's face, $f$, which may be the height measured from the part of the forehead above and between the user's eyebrow to the user's menton.

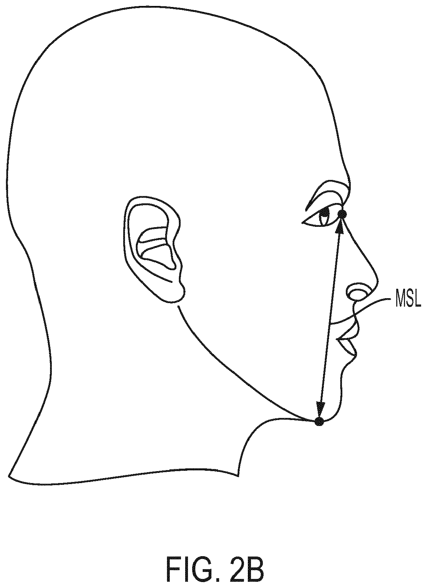

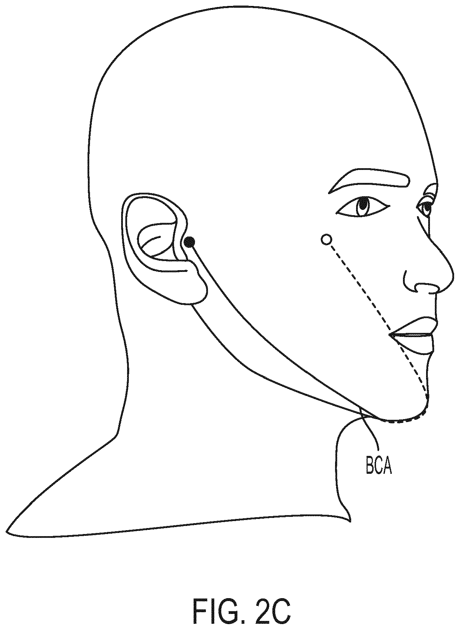

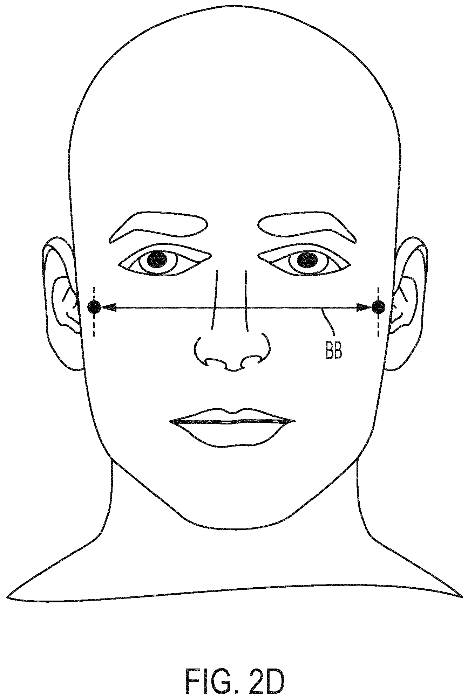

FIG. 2B shows an example face height measurement, which may be a distance between a user's menton and sellion, $MSL$. FIG. 2C shows an example jaw length measurement, which may refer to the user's bitragion-chin-arc, $BCA$. FIG. 2D shows face width measurement, which may refer to the user's bizygomatic breadth, $BB$.

An electronic device may obtain **104** one or more upper body measurements using a scanning device of the electronic device. The scanning device may be, for example, an infrared (IR) scanner. An electronic device may identify one or more landmarks (or key points) of the user's anatomy that the scanning device scans. For instance, a scanning device may identify one or more facial landmarks of a user's face that is scanned. A facial landmark refers to a key point on a human face image. Example facial landmarks may include, without limitation, the caps and domes of the nose and chin, curves of the mouth, curves around the nose and eyes, ridges of the nose, ridges of the lips and/or the like.

A facial landmark may be defined by their real coordinates (such as (x,y, z)) on a facial image. For example, an electronic device may identify a set of facial landmarks for a user based on an image of the user's face that the scanning device or image capture device captures. An electronic device may identify a set of facial landmarks using one or more suitable facial landmark detection algorithms such as, for example, one or more holistic methods, one or more constrained local model methods, and/or one or more regression-based methods.

In an embodiment, an electronic device may generate a three-dimensional map of a user's face and/or shoulders.

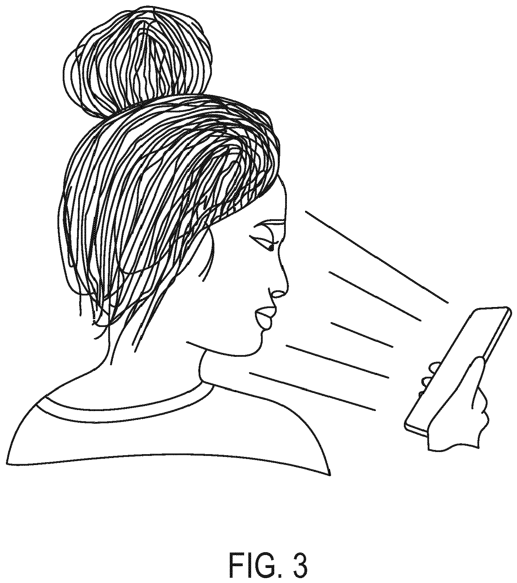

For instance, an IR scanner may produce IR light that illuminates the portion of the user's body of interest (e.g., face or face and shoulders). The IR scanner may include a dot projector that produces dots of IR light which is used to generate a three-dimensional map of the illuminated area. The IR scanner may include an IR camera, which may capture one or more images of the dot pattern and the IR light that is being reflected from the user's face. FIG. 3 illustrates an example diagram of using a scanner to obtain upper body measurements according to an embodiment.

In various embodiments, an electronic device may determine or estimate one or more facial measurements based on the distance between one or more dots of a three-dimensional map of a user's face and/or shoulders. For instance, an electronic device may determine a distance between one or more dots representing the vertex of a user's head of a three-dimensional map of the user's face and one or more dots representing the user's menton. The electronic device may translate this distance to a measurement of the user's head height. For instance, an electronic device may count the number of dots present between a representation of the vertex of a user's head and the user's menton on a three-dimensional map, and may translate the number of dots to a head height measurement of the user.

In another embodiment, an electronic device may obtain **104** one or more upper body measurements from a user. For instance, a user may provide one or more upper body measurements to an electronic device via a user interface such as, for example, a touchscreen, a keypad and/or the like.

An electronic device may also obtain **104** one or more upper body measurements from a user based on one or more images of the user. An electronic device may obtain one or more images of a user. For instance, an electronic device may obtain one or more images of a user from a camera roll of the electronic device, from an application of the electronic device, or from a source remote from the electronic device. A user may select the image or images to be used. Once one or more images of a user have been obtained **104**, an electronic device may analyze the image(s) to determine one or more upper body measurements of the users. For example, the electronic device may perform one or more image processing methods to extract one or more facial parameters.

In various embodiments, an electronic device may receive **106** one or more other user characteristics. A user characteristic may be information about a user that may affect or factor into the determination of one or more body measurements for the user. An example may be gender, race, ethnicity, age and/or the like. The use of user characteristics may be optional and voluntary. A user may opt not to provide such information if he or she chooses.

A user may provide one or more user characteristics to an electronic device via an input interface. A user may provide one or more user characteristics in response to being prompted for such information. Alternatively, an electronic device may retrieve one or more user characteristics from one or more data stores.

In another embodiment, one or more user characteristics may be automatically determined by an electronic device. For example, an image capture device of an electronic device (such as a camera of a smart phone), may capture an image of a user's exterior, such as the user's face. The electronic device may use one or more computer vision techniques, for example, facial recognition algorithms, to determine one or more user characteristics for the use from the image. These characteristics may include, for example, gender, race, ethnicity, age and/or the like.

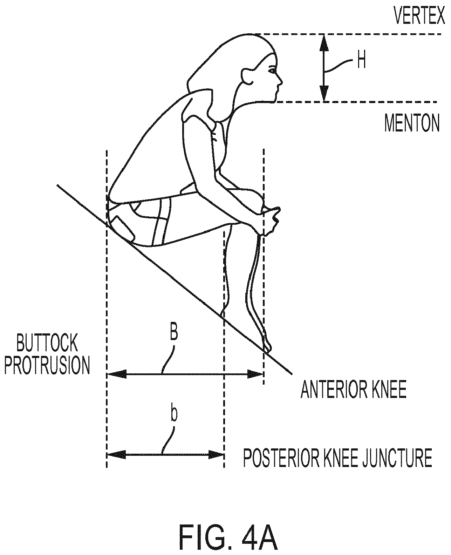

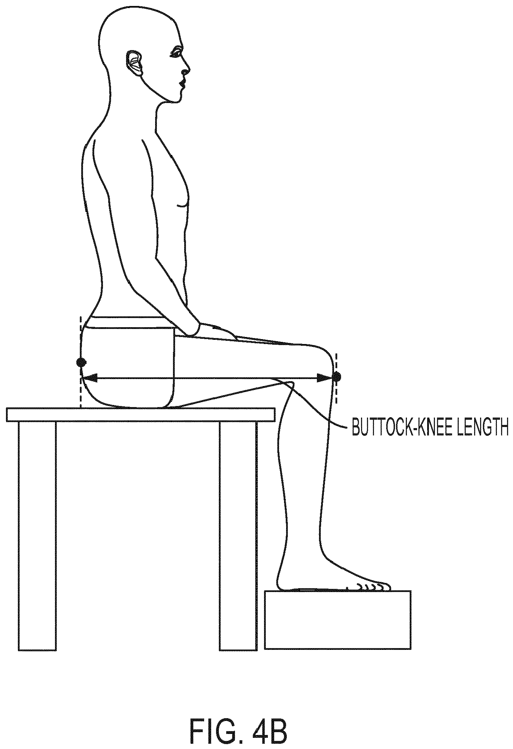

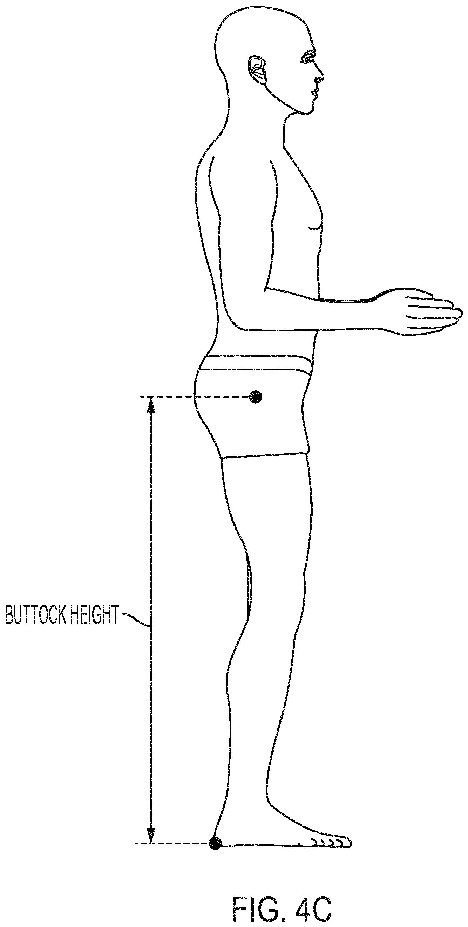

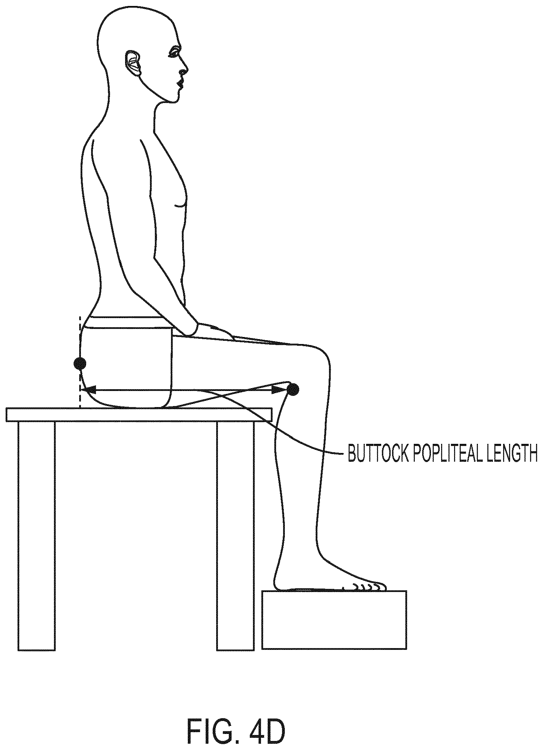

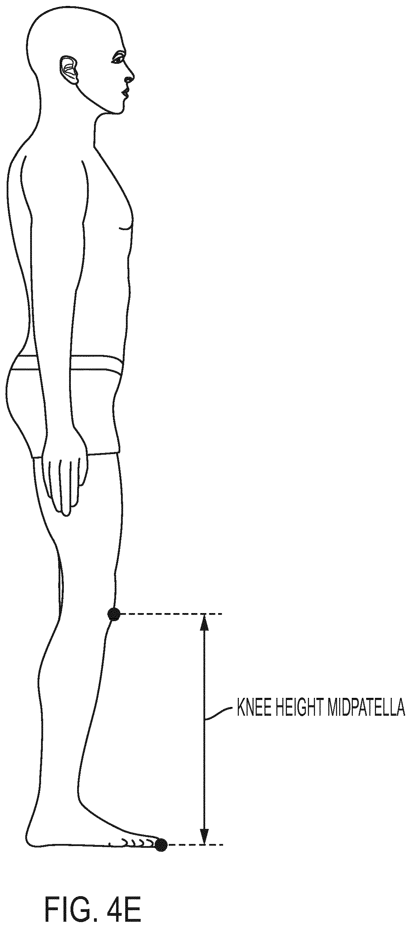

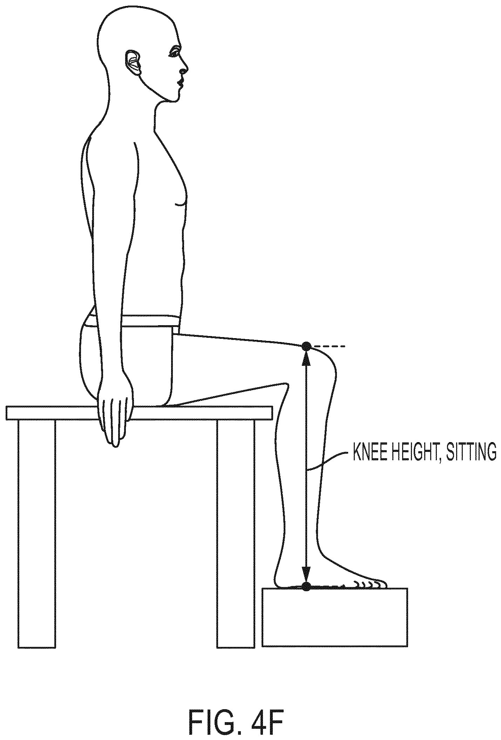

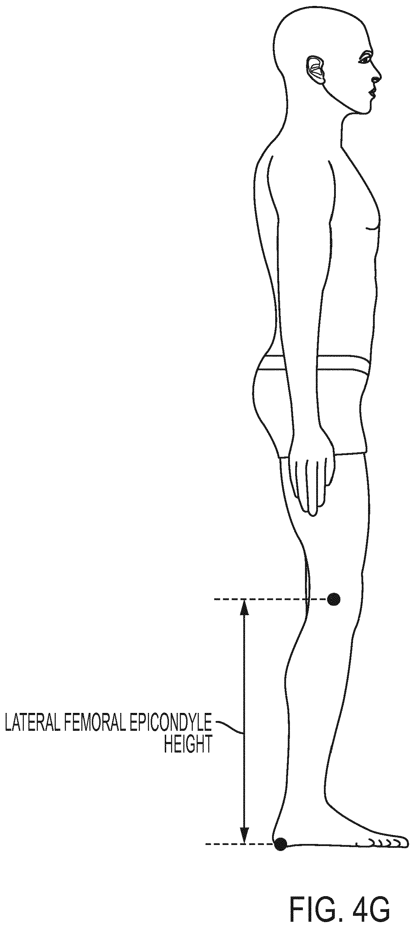

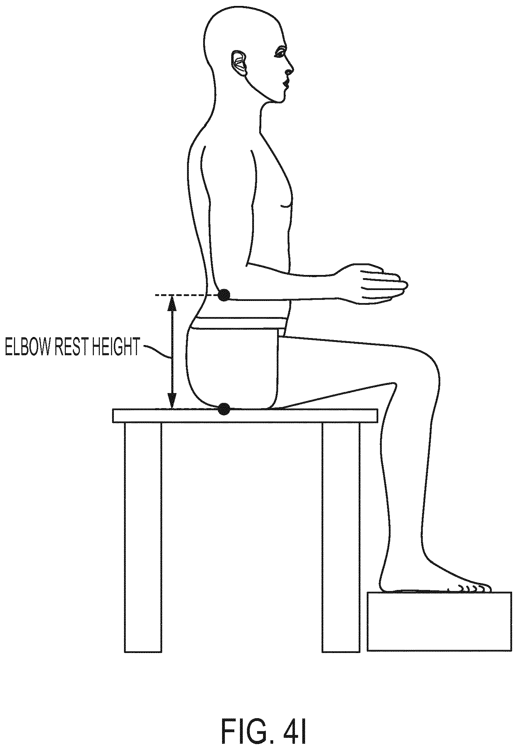

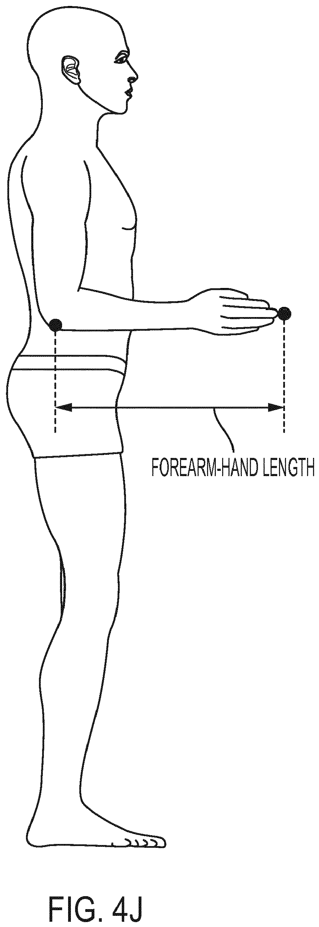

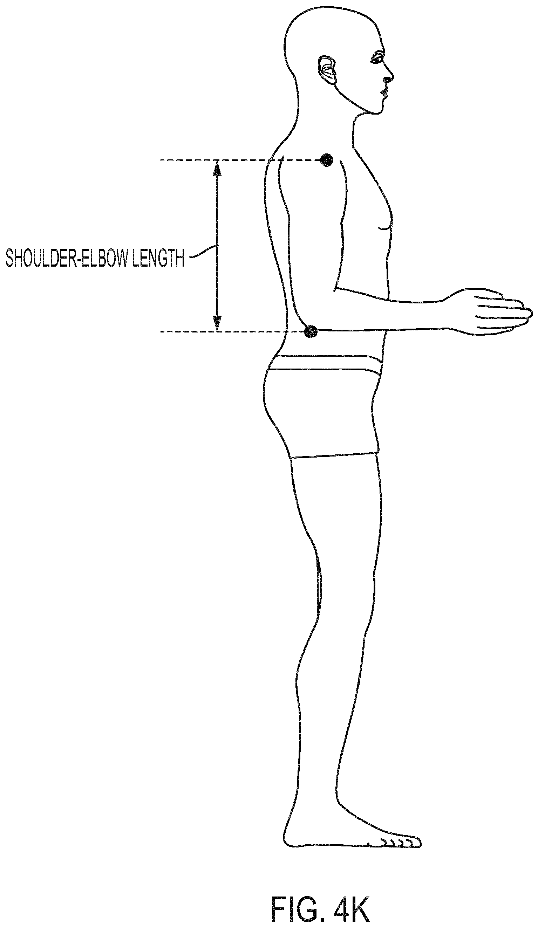

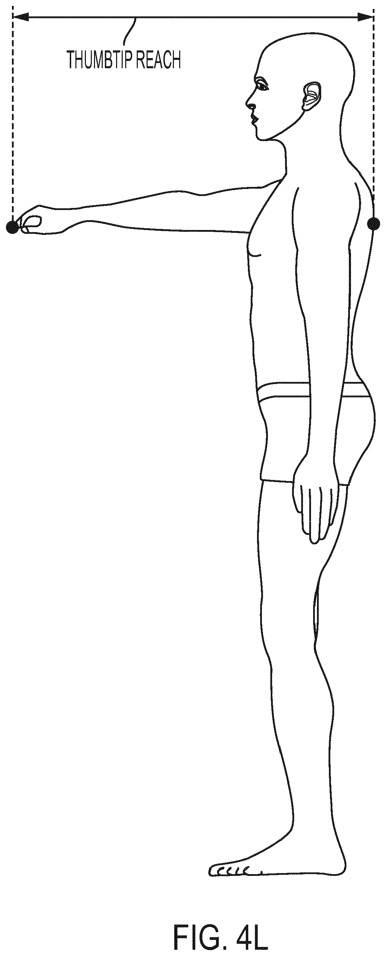

Referring back to FIG. 1, an electronic device may use the obtained upper body measurements and/or user characteristics to determine **108** one or more body measurements for the user. In an embodiment, a body measurement is a measurement associated with a part of a user's body that is not a part of the user's head, face or shoulders. For example, a body measurement may be a measurement associated with a user's legs, arms, hips, posterior, elbows, feet and/or the like. Examples of measurements associated with a user's legs may include, without limitation, buttock protrusion, posterior knee juncture, buttock-knee length, buttock height, buttock popliteal length, knee height midpatella, knee height (sitting), and/or lateral femoral epicondyle height, as illustrated in FIGs. 4A-4G.

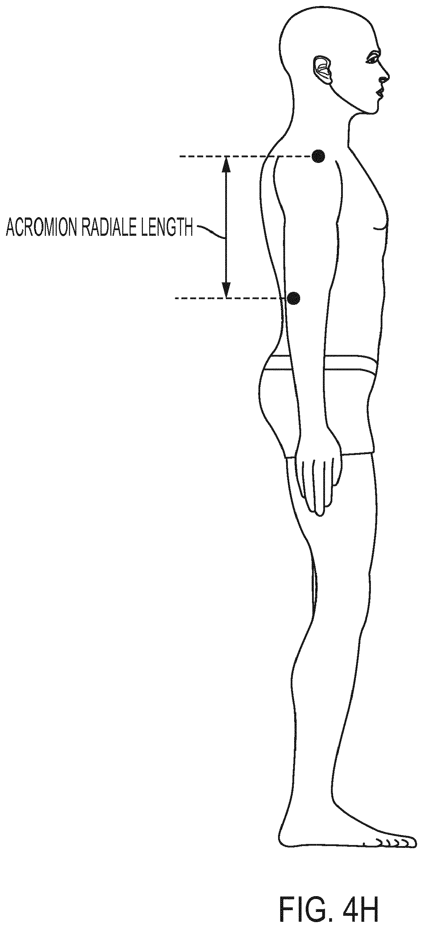

Examples of measurements associated with a user's arms may include, without limitation, an acromion radiale length, an elbow rest height, a forearm-hand length, a shoulder-elbow length, and/or a thumbtip reach, as illustrated in FIGs. 4H-4L.

The dimensions of individual parts of a body may correspond to one or more other parts of the body. Some parts may be loosely correlated, while others may be heavily dependent on the size of other parts. For example, the length of a person's legs is often characteristic of the height of that person's entire body.

As an example, a person's body height may be correlated to the person's palm length, head height and face height. A person's body height may be approximately 10 times the person's palm height. A person's body height may be approximately 7.5-8 times the person's head height. A person's body height may be approximately 10 times the person's face height.

Head and face dimensions tend to have more complex patterns than other components on the body. The height of an adult's head generally varies between 21 and 23 cm. A person's head height can be correlated to the person's body length by a certain multiple (See Table 1 below for examples).

Table 1. Dimensional relations between Human height and Head size

| Adult height | Head |
|---|---|
| 160 cm | 7 x times |
| 170 cm | 7 ½ x times |
| 175 cm | 7 ¾ x times |
| 180 - 190 cm+ | 8 x times |

The width of an adult head typically equals approximately half the width of the thigh (the distance between the heads of femur bones). The shoulder width is most closely related to the body height and pelvis width. The width of the shoulders for an adult is approximately 25% of body length. The width of the shoulders is typically equal to approximately 2 times head height.

Shoulder length typically equals approximately the length of two palms, or two faces, or a half-length head, and it is close to the length of half of the spine. Palm length typically equals approximately the height of the face. The dimensions of all three phalanges relate to each other in a ratio of 5:3.

An adult's leg length is approximately 40% of the length of the entire body and 136-185% of the torso length. Approximately 4 times head height is approximately equal to the length of an outer leg, while approximately 3.5 times head height is approximately equal to the length of the inner leg. Consequently, the knee joint is in the middle of the leg.

A hip length corresponds to approximately 1 3/8 head height or 1/4 of entire body height. Hip width, defined by the length of the head of the femur of the sides of the body (Posterior Hip) distance, equals approximately 1.5 times head height for men (or approximately 2 times face height faces), and approximately 1 ¾ times head height for women.

Table 2 illustrates example body parts, correlations and representative variables.

Table 1. Measurements and Correlations

| Letter | Body part | Correspondent measurement |
|---|---|---|
| F | Head height | 7 ½ - 8x body height (See Table 1) |
| f | Face height (head w/o forehead) | 10x body height / palm length |
| F | Head height | 13% of the body length |
| F | Head height | 4x length of the nose |
| g | Head width | ½ thigh width |
| S | Shoulders width | ¼ body length |
| S | Shoulders width | 2x head height |
| L | Leg length | 4x head height |
| H | Hip length | 1 3/8x head height or 48% of Leg length |
| W | Hip width (men) | 1.5x men's head height or 2x face heights |
| W | Hip width (women) | 1 ¾ x women's head height |
| SP | Seat Pitch | Seat pitch refers to the space between a point on one seat and the same point on the seat in front of it |
| SW | Seat Width | Width of the Seat |

In various embodiments, one or more body part correlations may be dependent on one or more user characteristics such as gender, age, race or ethnicity. For instance, the average MSL, BCA or BB measurements may be different for men and women. Furthermore, a coefficient such as the ratio between L and MSL may be different for men and women. Similarly, one or more of these measurements may differ for women and/or men based on race, ethnicity and/or age.

In various embodiments, one or more body part correlations may be stored in one or more data stores. The correlations may be accessed to determine 108 one or more body measurements. For example, an electronic device may estimate from a facial scan that a user's head height is approximately 22 cm. From this measurement, the electronic device may estimate the user's body height as 165-176 cm (7.5-8x head height), the user's leg length as 88 cm (4x head height), and the user's hip length as 30.25 cm (1 3/8x head height).

In various embodiments, one or more body part correlation dependencies may be stored in one or more data stores. For instance, one or more correlations between a body part measurement and one or more user characteristics (such as gender, age, race and/or ethnicity) may be store in one or more data stores. This information may be stored in a manner such that it is associated with a particular body part measurement and/or user characteristic(s).

Correlations may be stored in one or more data stores local to an electronic device. Alternatively, correlations may be stored in one or more data stores that are located remotely from the electronic device but that are accessible by the electronic device. An electronic device may access one or more correlations, select one or more correlations to apply based on a body measurement of interest, and apply the correlation to the upper body measurement(s) to obtain one or more body measurements.

In an embodiment, an electronic device may determine **108** one or more body measurements by performing one or more calculations that are relevant to the body measurements and which are based on at least a portion of the obtained upper body measurements and/or at least a portion of the obtained user characteristics. For example, an electronic device may determine the distance between a user's buttock protrusion and anterior knee position, B, based on the user's head height, H. For example, B = 2 * H.

As another example, an electronic device may determine the distance between a user's buttock protrusion and anterior knee position, B, according to the following linear formula:

$$B = C_0 + C_1 * MSL + C_2 * BCA + C_3 * BB$$

Where:

$C_0$ represents a constant coefficient, selected according to one or more user characteristics associated with a user (such as gender and race);

$C_1$ represents a constant coefficient, selected according to one or more user characteristics associated with a user (such as gender and race);

MSL represents a measurement of a length between a user's menton and sellion

$C_2$ represents a constant coefficient, selected according to one or more user characteristics associated with a user (such as gender and race);

BCA represents a measurement of a user's bitragion-chin-arc.

$C_3$ represents a constant coefficient, selected according to one or more user characteristics associated with a user (such as gender and race);

BB represents a measurement of a user's bizygomatic breadth.

Referring back to FIG. 1, an electronic device may use at least a portion of the obtained seat measurements and at least a portion of the determined body measurements to generate 110 a visual body representation of the user relative to the identified seat. In various embodiments, an electronic device may use one or more 3D modeling techniques, virtual reality or augmented reality rendering techniques, and/or the like to generate a visual body representation of a user. For example, an electronic device may generate a three-dimensional visual body representation that includes a semi-transparent user body image in a virtual reality environment with a virtual panoramic view of the seat location (e.g., of the plane, car, train, etc. from the seat). As another example, an electronic device may generate a three-dimensional visual body representation that includes a semi-transparent user body image in an augmented reality environment on the surface projected by the user to simulate the seat location.

For example, an electronic device may have determined that a seat of interest has a seat width of 35 cm and a seat pitch of 47 cm. The electronic device may also have determined that the user is a male and has a head height of approximately 22 cm. The electronic device may apply correlations to estimate that the user's shoulder width is approximately 44 cm (2x head height), and that the distance between the user's buttock protrusion and anterior knee position (B) is approximately 44 cm (2x head height).

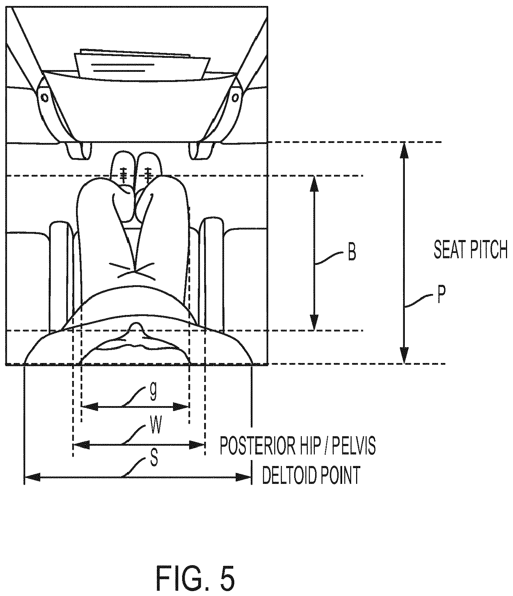

The electronic device may generate **110** a visual representation of the seat having the identified seat width and seat pitch. The visual representation may also include a representation of the user having the determined body measurements. The representation of the user may be imposed in a manner relative to the seat to provide the user with a sense of the proportion and comfort of the seat relative to the user's dimensions. For instance, FIG. 5 illustrates an example visual representation showing one or more user body measurements (B, g, S) relative to one or more seat measurements (SW, P).

In various embodiments, an electronic device may generate **110** a visual representation of user relative to a seat that is labeled to indicate a comfort level for a user. The visual representation may be shaded, color-coded or otherwise labeled to indicate a specific comfort level. For example, an image may be shaded green and blue to indicate comfortable, and red to indicate uncomfortable. Additional and/or alternate shadings or markings may be used to indicate comfort level according to this disclosure.

A comfort level may be determined by analyzing at least a portion of the seat measurements, a user's body measurements and one or more threshold values. For instance, an electronic device may determine whether a user's hip width is less than the seat width by at least 2 cm. If so, the electronic device may determine that the seat is comfortable for the user. As another example, an electronic device may determine whether a user's shoulder width is no more than 1 cm greater than the width of the seat back. If so, the electronic device may determine that the seat is comfortable for the user, otherwise, the seat may be determined to be uncomfortable.

A comfort level may be determined based on a combination of different threshold considerations. For instance, in an embodiment, a seat may be labeled as comfortable for a user if the user's hip width satisfies a threshold condition with respect to the seat width, if the user's shoulder width satisfies a threshold condition with respect to the width of the seat back, and if the distance between a user's buttock protrusion and anterior knee position satisfies a threshold condition. Different variations or combinations of threshold conditions may be considered in determining a comfort level of a seat for a user.

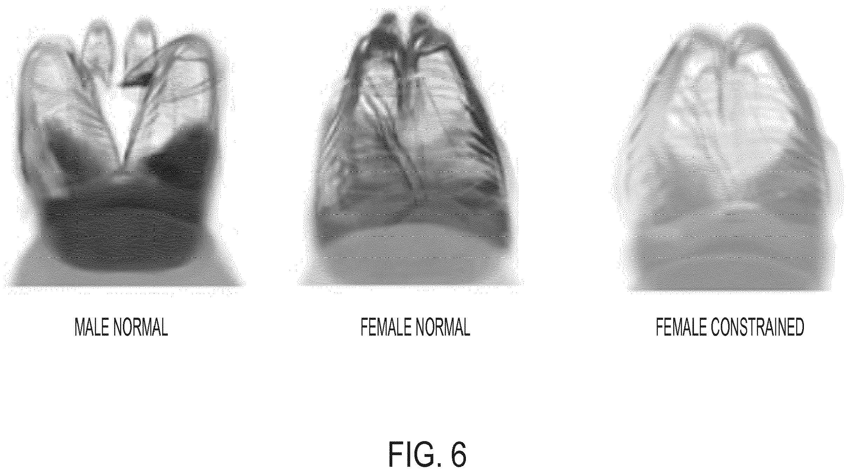

Referring back to FIG. 1, an electronic device may cause **112** the visual representation to be displayed to a user. The visual representation may be displayed to a user via a display device of the electronic device. FIG. 6 illustrates example visual representations that may be displayed to a user according to various embodiments.

In various embodiments, an electronic device may cause the position of a seat to be adjusted based on at least a portion of body measurements associated with the user. For example, a user who is renting a car or riding in an autonomous vehicle may be able to automatically adjust the position of a seat by providing one or more upper body measurements to an electronic device. The electronic device may be a user's electronic device, such as via an application that resides on the user's smartphone, tablet and/or the like. In another example, the electronic device may be one present in or at the seat location. For instance, an autonomous vehicle may have an electronic device present in the vehicle (such as, for example, a tablet built into the back of a seat). A rider may be able to scan his or her face, and have the vehicle automatically adjust the position of the rider's seat based on body measurements determined for the rider. For example, an electronic device may determine one or more positions of the seat such that a user's body measurements satisfy the threshold conditions for a "comfortable" comfort level for the seat, and may cause the seat to be adjusted to such positions.

An electronic device may be in communication with a seat via wireless, short range communication protocols, near field communication protocols and/or the like. The electronic device may send at least a portion of the body measurements for a user to the seat. The seat may receive the body measurements, and may cause the seat position to be adjusted based on the measurements. For instance, the seat may move backwards or forwards based on the user's leg length, or may lean the seat backward or forward based on the user's shoulder width. Additional and/or alternate adjustments may be made within the scope of this disclosure.

In an alternate embodiment, an electronic device may send one or more instructions to a seat that cause the seat position to change in one or more ways. The instructions may be based on at least a portion of the user's body measurements.

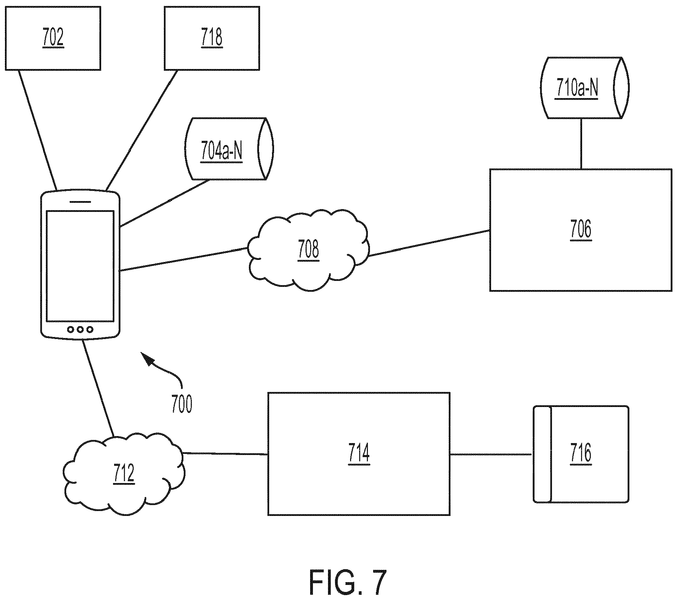

FIG. 7 illustrates an example system of generating a representation of a seat location according to an embodiment. As illustrated by FIG. 7, a system may include an electronic device **700**. As discussed throughout this disclosure, an electronic device may be a smartphone, a smartwatch, a tablet, a laptop computer, and/or the like. In certain embodiments, an electronic device may include an application that resides on the electronic device which may be accessed to generate a representation of a seat location according to an embodiment.

As illustrated in FIG. 7, an electronic device **700** may be in communication with a scanning device **702**. A scanning device **702** may be a device capable of obtaining one or more upper body or other body measurements of a user by scanning at least a portion of the user's anatomy. As described in more detail in this disclosure, an example of a scanning device **702** may be an IR scanner. In some embodiments, a scanning device **702** may be a component of the electronic device **700**. In other embodiments, a scanning device **702** may be communicatively coupled to an electronic device **700.**

In an embodiment, an electronic device **700** may be in communication with an image capture device **718.** An image capture device **718** may be integrated with an electronic device **700** or may be communicatively coupled to an electronic device 700. An example of an image capture device **718** may be a camera.

In various embodiments, an electronic device **700** may include or may be in communication with one or more data stores **704a-N.** One or more data stores may store information associated with a user or with a seat according to various embodiments. For instance, a data store **704a-N** may include body part correlation information, user characteristics or other user information. Additional and/or alternate information or data may be stored in a data store **704a-N** according to an embodiment.

An electronic device may be in communication with one or more backend electronic devices **706** via a communication network **708.** A backend electronic **706** device may reside remotely from the electronic device **700.** In various embodiments, a communication network **708** may be a local area network (LAN), a wide area network (WAN), a mobile or cellular communication network, an extranet, an intranet, the Internet and/or the like.

In various embodiments, a backend electronic device **706** may include or host one or more systems with which an electronic device communicates. For instance, a backend electronic device may host a measurement system as described in this disclosure. Alternatively, an electronic device **700** may include one or more such systems. As illustrated by FIG. 7, a backend electronic device may include or be in communication with one or more data stores **710a-N.**

In various embodiments, an electronic device may be in communication with one or more controllers **714** associated with one or more seats **716** via a communication network **712.** As described above, an electronic device **700** may send one or more instructions to a controller **714** regarding movement of or adjustment of a seat, and the seat may cause the position of the seat to be adjusted in accordance with the received instructions.

FIG. 8 depicts an example of internal hardware that may be used to contain or implement the various computer processes and systems as discussed above. For example, the mobile electronic device discussed above may include hardware such as that illustrated in FIG. 8.

An electrical bus **800** serves as an information highway interconnecting the other illustrated components of the hardware. Processor **805** is a central processing device of the system, configured to perform calculations and logic operations required to execute programming instructions. As used in this document and in the claims, the terms "processor" and "processing device" may refer to a single processor or any number of processors in a set of processors, whether a central processing unit (CPU) or a graphics processing unit (GPU) or a combination of the two. Read only memory (ROM), random access memory (RAM), flash memory, hard drives and other devices capable of storing electronic data constitute examples of memory devices **825.** A memory device may include a single device or a collection of devices across which data and/or instructions are stored.

An optional display interface **830** may permit information from the bus **800** to be displayed on a display device **835** in visual, graphic or alphanumeric format. An audio interface and audio output (such as a speaker) also may be provided. Communication with external devices may occur using various communication devices **840** such as a transmitter and/or receiver, antenna, an RFID tag and/or short-range or near-field communication circuitry. A communication device **840** may be attached to a communications network, such as the Internet, a local area network or a cellular telephone data network.

The hardware may also include a user interface sensor **845** that allows for receipt of data from input devices **850** such as a keyboard, a mouse, a joystick, a touchscreen, a remote control, a pointing device, a video input device and/or an audio input device. The hardware may also include a scanning device **855**, such as an infrared scanner, for obtaining information about a user's physical characteristics. A positional sensor **815** and motion sensor **810** may be included as input of the system to detect position and movement of the device. The hardware may include an image capturing device **820.**

It will be appreciated that the various above-disclosed and other features and functions, or alternatives thereof, may be desirably combined into many other different systems or applications or combinations of systems and applications. Also that various presently unforeseen or unanticipated alternatives, modifications, variations or improvements therein may be subsequently made by those skilled in the art which are also intended to be encompassed by the following claims.

**Claims**

1.  A system, comprising:

    an electronic device; and
    a computer-readable storage medium comprising one or more programming instructions that, in particular when executed, are configured to cause the electronic device to:

    receive a selection or indication of a seat,
    obtain one or more seat measurements associated with the seat,
    obtain one or more upper body measurements associated with a user,
    determine one or more body measurements for the user based on at least a portion of the one or more upper body measurements,
    generate a visual representation of the user relative to the seat based on at least a portion of the seat measurements and at least a portion of the body measurements, and
    cause the visual representation to be displayed on a display device of the electronic device.

**2.** The system of claim 1, wherein the instructions are further configured to:
determine one or more user characteristics associated with the use or at least a portion thereof.

**3.** The system of any of the preceding claims, wherein the one or more programming instructions that, when executed, are configured to cause the electronic device to receive a selection of a seat comprise one or more programming instructions that, when executed, cause the electronic device to receive a selection of the seat from a seat map from the user.

**4.** The system of any of the preceding claims, wherein the one or more seat measurements associated with the seat comprise one or more measurements associated with one or more of the following:

a seat base of the seat;
a seat back of the seat;
a headrest of the seat; or
an arm rest of the seat.

**5.** The system of any of the preceding claims, wherein the one or more programming instructions that, when executed, are configured to obtain one or more seat measurements associated with the seat comprise one or more programming instructions that, when executed, cause the electronic device to query a measurement system located remotely from the electronic device for the one or more seat measurements using a unique identifier associated with the seat.

**6.** The system of any of the preceding claims, wherein the one or more programming instructions that are configured to cause the electronic device to obtain one or more seat measurements associated with the seat comprise one or more programming instructions that, when executed, are configured to cause the electronic device to:

receive, from an image capture device, an image of the seat; and
perform one or more image processing techniques on the image to obtain the one or more seat measurements associated with the seat.

**7.** The system of any of the preceding claims, wherein the one or more programming instructions that, when executed, are configured to cause the electronic device to obtain one or more upper body measurements associated with the user comprise one or more programming instructions that, when executed, are configured to cause the electronic device to scan, by an infrared scanner of the electronic device, at least a portion of the user's face to generate a three-dimensional map of the user's face.

**8.** The system of any of the preceding claims, wherein the one or more or more programming instructions that, when executed, are configured to cause the electronic device to determine one or more user characteristics associated with the user comprise one or more or more programming instructions that, when executed, are configured to cause the electronic device to:

obtain from an image capture device, an image of the user's face; and
apply one or more computer vision algorithms to identify the one or more user characteristics.

**9.** The system of any of the preceding claims, wherein the one or more programming instructions that, when executed, are configured to cause the electronic device to generate the visual representation of the user relative to the seat comprise one or more programming instructions that, when executed, are configured to cause the electronic device to generate the visual representation of the user relative to the seat that comprises an indication of a comfort level associated with the seat for the user.

**10.** The system of claim 1, wherein the computer-readable storage medium further comprises one or more programming instructions that, when executed, are configured to cause the electronic device to send one or more instructions to a controller associated with the seat to adjust a position of the seat.

**11.** The system of any of the preceding claims, wherein the one or more instructions comprise one or more of the body measurements, wherein the controller is configured to cause the position of the seat to be adjusted in order to accommodate the one or more body measurements.

**12.** A method comprising:

receiving, by an electronic device, a selection of a seat;

obtaining one or more seat measurements associated with the seat;

obtaining one or more upper body measurements associated with a user;

determining one or more user characteristics associated with the user;

determining one or more body measurements for the user based on at least a portion of the one or more upper body measurements and/or at least a portion of the one or more user characteristics;

generating a visual representation of the user relative to the seat based on at least a portion of the seat measurements and at least a portion of the body measurements; and

causing the visual representation to be displayed on a display device of the electronic device.

13. The method of claim 11, wherein receiving the selection of a seat comprises receiving the selection of the seat from a seat map from the user.

14. The method of any of the method claims above, wherein the one or more seat measurements associated with the seat comprise one or more measurements associated with one or more of the following:

a seat base of the seat;

a seat back of the seat;

a headrest of the seat; or

an arm rest of the seat.

15. The method of any of the method claims above, wherein obtaining one or more seat measurements associated with the seat comprises querying a measurement system located remotely from the electronic device for the one or more seat measurements using a unique identifier associated with the seat.

16. The method of any of the method claims above, wherein obtaining one or more seat measurements associated with the seat comprises:

receiving, from an image capture device, an image of the seat; and

performing one or more image processing techniques on the image to obtain the one or more seat measurements associated with the seat.

17. The method of any of the method claims above, wherein obtaining one or more upper body measurements associated with the user comprises scanning, by an infrared scanner of the electronic device, at least a portion of the user's face to generate a three-dimensional map of the user's face.

18. The method of any of the method claims above, wherein determining one or more user characteristics associated with the user comprises:

obtaining from an image capture device, an image of the user's face; and

applying one or more computer vision algorithms to identify the one or more user characteristics.

19. The method of any of the method claims above, wherein generating the visual representation of the user relative to the seat comprises generating the visual representation of the user relative to the seat that includes an indication of a comfort level associated with the seat for the user.

20. The method of any of the method claims above, further comprising:

sending one or more instructions to a controller associated with the seat to adjust a position of the seat, wherein the one or more instructions comprise one or more of the body measurements, wherein the controller is configured to cause the position of the seat to be adjusted in order to accommodate the one or more body measurements.

```
┌─────────────────────┐
│  RECEIVE SELECTION  │ ⌐ 100
│      OF SEAT        │
└─────────────────────┘
           │
           ▼
┌─────────────────────┐
│    OBTAIN SEAT      │ ⌐ 102
│   MEASUREMENTS      │
└─────────────────────┘
           │
           ▼
┌─────────────────────┐
│  OBTAIN UPPER BODY  │ ⌐ 104
│   MEASUREMENTS OF   │
│       USER          │
└─────────────────────┘
           │
           ▼
┌─────────────────────┐
│    RECEIVE USER     │ ⌐ 106
│   CHARACTERISTICS   │
└─────────────────────┘
           │
           ▼
┌─────────────────────┐
│  DETERMINE BODY     │ ⌐ 108
│  MEASUREMENTS FOR   │
│       USER          │
└─────────────────────┘
           │
           ▼
┌─────────────────────┐
│  GENERATE VISUAL    │ ⌐ 110
│  REPRESENTATION OF  │
│     USER/SEAT       │
└─────────────────────┘
           │
           ▼
┌─────────────────────┐
│   CAUSE VISUAL      │ ⌐ 112
│ REPRESENTATION TO   │
│    BE DISPLAYED     │
└─────────────────────┘
```

FIG. 1

VERTEX

FOREHEAD

H

f

MENTON

FIG. 2A

FIG. 2B

FIG. 2C

FIG. 2D

FIG. 3

FIG. 4A

BUTTOCK-KNEE LENGTH

FIG. 4B

BUTTOCK HEIGHT

FIG. 4C

BUTTOCK POPLITEAL LENGTH

FIG. 4D

FIG. 4E

KNEE HEIGHT, SITTING

FIG. 4F

LATERAL FEMORAL EPICONDYLE
HEIGHT

FIG. 4G

ACROMION RADIALE LENGTH

FIG. 4H

ELBOW REST HEIGHT

FIG. 4I

FOREARM-HAND LENGTH

FIG. 4J

SHOULDER-ELBOW LENGTH

FIG. 4K

THUMBTIP REACH

FIG. 4L

FIG. 5

MALE NORMAL FEMALE NORMAL FEMALE CONSTRAINED

FIG. 6

FIG. 7

FIG. 8

EP 3 502 934 A1

Europäisches
Patentamt

European
Patent Office

Office européen
des brevets

## EUROPEAN SEARCH REPORT

Application Number

EP 18 21 4051

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 20 2013 002800 U1 (FAURECIA SIEGES AUTOMOBILE [FR]) 17 July 2013 (2013-07-17) * the whole document * * paragraph [0002] * * paragraph [0004] * * paragraph [0011] * * paragraph [0016] * * paragraph [0042] * ----- | 1-20 | INV. G06F17/50 |
| X | DE 10 2010 028580 A1 (BAYERISCHE MOTOREN WERKE AG [DE]) 10 November 2011 (2011-11-10) * the whole document * * paragraph [0001] * * paragraph [0006] * * paragraph [0008] * * paragraph [0011] * * paragraph [0014] * ----- | 1-20 | |
| A | DE 10 2007 027563 A1 (LEAR CORP [US]) 17 January 2008 (2008-01-17) * the whole document * * paragraph [0017] - paragraph [0021] * * paragraph [0025] * * paragraph [0028] * * figures 2, 3, 6 * ----- | 1-20 | TECHNICAL FIELDS SEARCHED (IPC) G06F |

The present search report has been drawn up for all claims

| Place of search | Date of completion of the search | Examiner |
|---|---|---|
| Munich | 17 April 2019 | Wellisch, J |

EPO FORM 1503 03.82 (P04C01)

**EP 3 502 934 A1**

## ANNEX TO THE EUROPEAN SEARCH REPORT
## ON EUROPEAN PATENT APPLICATION NO.

EP 18 21 4051

This annex lists the patent family members relating to the patent documents cited in the above-mentioned European search report.
The members are as contained in the European Patent Office EDP file on
The European Patent Office is in no way liable for these particulars which are merely given for the purpose of information.

17-04-2019

| Patent document cited in search report | Publication date | Patent family member(s) | Publication date |
|---|---|---|---|
| DE 202013002800 U1 | 17-07-2013 | CN 203372086 U<br>DE 202013002800 U1<br>FR 2988653 A1<br>JP 2015512827 A<br>US 2015084985 A1<br>WO 2013144498 A1 | 01-01-2014<br>17-07-2013<br>04-10-2013<br>30-04-2015<br>26-03-2015<br>03-10-2013 |
| DE 102010028580 A1 | 10-11-2011 | NONE | |
| DE 102007027563 A1 | 17-01-2008 | DE 102007027563 A1<br>GB 2440238 A<br>US 2008015719 A1 | 17-01-2008<br>23-01-2008<br>17-01-2008 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62608724 A